# EUROPEAN PATENT SPECIFICATION

(11) **EP 4 095 810 B1**
(45) Date of publication and mention of the grant of the patent: **11.11.2026**
(21) Application number: 22173636.6
(22) Date of filing: 16.05.2022
(51) Int. Cl.: G06V 10/44, G06V 20/69, G06V 10/762

(54) **METHOD AND APPARATUS FOR ANALYSING AN IMAGE OF A MICROLITHOGRAPHIC MICROSTRUCTURED COMPONENT**
VERFAHREN UND GERÄT ZUM ANALYSIEREN EINES BILDES EINES MIKROLITHOGRAFISCHEN, MIKROSTRUKTURIERTEN BAUTEILS
PROCÉDÉ ET APPAREIL D'ANALYSE D'UNE IMAGE D'UN COMPOSANT MICROSTRUCTURÉ MICROLITHOGRAPHIQUE

(30) Priority: 27.05.2021 DE 102021113764
(43) Date of publication of application: 30.11.2022
(73) Proprietor: Carl Zeiss SMT GmbH, 73447 Oberkochen (DE)
(72) Inventor: Laengle, Mario, 07749 Jena (DE); Klochkov, Dmitry, 73525 Schwaebisch-Gmuend (DE)
(74) Representative: Frank, Hartmut

(56) References cited:
- CAO LIANG ET AL: "Automatic SRAF printing detection based on contour extraction", PROCEEDINGS OF SPIE; [PROCEEDINGS OF SPIE ISSN 0277-786X VOLUME 10524], SPIE, US, vol. 10451, 16 October 2017 (2017-10-16), pages 104511J - 104511J, XP060095898, ISBN: 978-1-5106-1533-5, DOI: 10.1117/12.2280186
- SCHNEIDER L ET AL: "Framework for SEM contour analysis", PROCEEDINGS OF SPIE; [PROCEEDINGS OF SPIE ISSN 0277-786X VOLUME 10524], SPIE, US, vol. 10145, 28 March 2017 (2017-03-28), pages 1014513 - 1014513, XP060087819, ISBN: 978-1-5106-1533-5, DOI: 10.1117/12.2258059
- ERSOY O ET AL: "Skeleton-Based Edge Bundling for Graph Visualization", IEEE TRANSACTIONS ON VISUALIZATION AND COMPUTER GRAPHICS, IEEE, USA, vol. 17, no. 12, 1 December 2011 (2011-12-01), pages 2364 - 2373, XP011444667, ISSN: 1077-2626, DOI: 10.1109/TVCG.2011.233

## Description

This application claims priority of German Patent Application DE 10 2021 113 764.0 filed on May 27, 2021.

### BACKGROUND OF THE INVENTION

### Field of the invention

The invention relates to a method and to an apparatus for analysing an image of a microlithographic microstructured component, in particular of a mask or of a wafer.

### Prior art

Microlithography is used for producing microstructured components, such as integrated circuits or LCDs, for example. The microlithography process is conducted in what is called a projection illumination apparatus, which comprises an illumination device and a projection lens. The image of a mask (= reticle) illuminated by means of the illumination device is projected here by means of the projection lens onto a substrate (e.g. a silicon wafer) that is coated with a light-sensitive layer (photoresist) and arranged in the image plane of the projection lens, in order to transfer the mask structure onto the light-sensitive coating of the substrate.

As the structure sizes of both the masks used in the lithography process and the microlithographically structured wafers become ever smaller, the analysis and the processing or repair of these components is becoming ever more of a demanding challenge in practice.

Images acquired microscopically, among other things, using electron beams or ion beams are used for the analysis to ascertain any differences between the respective measurement image and a design image having the desired structure of the mask and to use them as a basis for repairing the mask or wafer. The images to be analysed (e.g. scanning electron microscope (SEM) recordings of a mask or a wafer) are here as a rule composed of a multiplicity of pixels, wherein each pixel is assigned an intensity value as a "greyscale value".

Different approaches are known in practice for differentiating, by way of contour extraction or detection, the coated or structure-carrying regions from the uncoated or structure-less regions of the mask or of the wafer. A conventional approach includes for example contour extraction or contour detection on the basis of the second derivative of the greyscale value profile in connection with the application of various filter mechanisms and algorithms for closing existing contours. A further known approach is based on the intensity values themselves (i.e. the zero-order derivative of the greyscale value profile) exceeding threshold values. For example: CAO LIANG ET AL: "Automatic SRAF printing detection based on contour extraction", SPIE, US, vol. 10451, pages 104511J-104511J, 16 October 2017, DOI: 10.1117/12.2280186, discloses a contour extraction for SRAF printing detection.

It has frequently proven difficult here in practice to reliably distinguish between the segments that are to be separated from one another (i.e. the uncoated or structure-carrying region and the coated or structure-less region) during the analysis of comparatively strongly pixellated and possibly very noisy images. This is true in particular if the regions to be separated have on average approximately the same brightness as a result of a pronounced pixellation.

Against the above-mentioned background, the provision of a robust method that provides correct results for a great variety of different scenarios or microscopic recordings in practice represents a significant challenge.

### SUMMARY OF THE INVENTION

It is an object of the present invention to provide a method and an apparatus for analysing an image of a microlithographic microstructured component, which facilitate a reliable characterization while at least partially avoiding the above-described problems.

This object is achieved by means of the method and the apparatus, respectively, according to the features of the alternative independent claims.

Here and below, "relevant" edge fragment is understood to mean an edge fragment that is considered to be an actual boundary between the segments that are ultimately to be separated during the image analysis according to the invention, i.e. a boundary between a coated or structure-carrying region and an uncoated or structure-less region.

The invention is based in particular on the concept of initially finding all the edge pixels in a microscopically acquired image that is to be analysed and to isolate therefrom a plurality of edge fragments in order to only then remove irrelevant edge fragments (which in reality do not represent a boundary between a coated or structure-carrying and an uncoated or structure-less region) from the isolated edge fragments.

In embodiments of the invention, as will be described in more detail below, isolating edge fragments includes in particular, after skeletonization of the pixellated image (during which any broader edge fragments are replaced with edge fragments having a width of only one pixel), deleting or eliminating comparatively short branches (in particular those having the length of merely one pixel) and/or deleting or eliminating intersection points (i.e. points in which at least three lines intersect in the skeletonized image). The invention here includes in particular the principle of, despite the previously described elimination of branches and/or intersection points, initially holding on to the edge fragments that remain in this case, that is to say not yet eliminating them at this stage of the method and undertaking any classification in this respect into "relevant" and "irrelevant" only during a later method step.

In embodiments, the previously mentioned classification into "relevant" and "irrelevant" edge fragments takes place on the basis of the average intensity gradient of isolated edge fragments, wherein a value exceeding or falling below an appropriately defined threshold value can in turn be used as the basis as a quantitative criterion.

In embodiments of the invention, said threshold value is in turn preferably defined such that specific edge fragments (or the associated average intensity gradients) either are not taken into account when defining the threshold value or are reduced in terms of the gradient value.

Edge fragments that are not to be taken into account or are to be eliminated can in particular be, in embodiments, particularly short edge fragments, particularly high-contrast edge fragments, particularly low-contrast edge fragments and/or edge fragments located near a relatively brighter edge fragment. For defining the threshold value, edge fragments located near a comparatively higher-contrast edge fragment can furthermore also initially be reduced in terms of the average gradient value (thus be "weakened"). Such pre-processing can ensure that for example comparatively short edge fragments having a relatively high intensity contrast are "eliminated" when defining the threshold value for the classification (differentiation between "relevant" and "irrelevant" edge fragments) in order to avoid in this regard any falsification of the threshold value whose use is sensible due to "outliers" in the pixel distribution of the values of the average intensity gradient.

In embodiments of the invention, contiguous segments are ascertained on the basis of the relevant edge fragments without prior closing of gaps between the edge fragments. In embodiments of the invention, as will be described in more detail below, the pixels located in the region of the interruption between successive edge fragments are assigned in a distance-based manner even without the presence of completely closed edge paths, to be precise by virtue of an ascertainment for each of said pixels as to whether said pixel is positioned closer to the one region or to the other region of the adjoining regions (i.e. closer to the coated or the uncoated region). Not closing gaps in advance present between the edge fragments before contiguous segments are ascertained here has the advantage that the method according to the invention is accelerated (i.e. the required computation time is shortened) and, in addition, that the method is less susceptible to errors, because by electing to not close the edges in advance, any errors associated with such a step are also avoided.

According to an embodiment, irrelevant edge fragments are furthermore eliminated during the ascertainment of contiguous segments.

According to an embodiment, after contiguous segments have been ascertained, edge fragments are combined into object edges and the edge coordinates are computed in a subpixel-wise manner.

According to an embodiment, after edge fragments have been combined into object edges in this way, irrelevant object edges are eliminated.

According to an embodiment, after irrelevant object edges have been eliminated, a segment image is computed.

According to an embodiment, image pre-processing is carried out for reducing the noise component before a plurality of edge fragments are isolated.

According to an embodiment, isolating a plurality of edge fragments comprises eliminating branches whose lengths are below a specified value.

According to an embodiment, isolating a plurality of edge fragments comprises eliminating intersection points at which at least three edges intersect.

According to an embodiment, the image is divided by way of the segments into a total of two different regions which differ in terms of the material that is located in the respective region.

According to one embodiment, the microstructured component is a mask. The mask can be designed in particular for a working wavelength of less than 250 nm, in particular for a working wavelength of less than 200 nm, more particularly for a working wavelength of less than 15 nm.

According to a further embodiment, the microstructured component is a wafer.

The invention furthermore relates to an apparatus for analysing an image of a microlithographic microstructured component, wherein the apparatus is designed to carry out a method having the features described above.

With regard to advantages and preferred configurations of the device, reference is made to the above explanations in association with the method according to the invention.

Further refinements of the invention can be gathered from the description and the dependent claims. The invention is explained in greater detail below on the basis of exemplary embodiments illustrated in the accompanying figures.

### BRIEF DESCRIPTION OF THE DRAWINGS

In the figures:
- Figure 1: shows a flowchart for explaining the possible sequence of one embodiment of the method according to the invention;
- Figure 2: shows an exemplary result of an edge detection carried out as part of the method according to the invention of Figure 1;
- Figures 3a-3b: show results of an isolation of edge fragments, performed as part of the method according to the invention, including elimination of branches (Figure 3a) and intersection points (Figure 3b);
- Figures 4a-4b: show schematic illustrations for elucidating the elimination of a branch (Figure 4a) or of an intersection point (Figure 4b);
- Figure 5: shows a diagram for elucidating a threshold value-based classification of edge fragments taking place as part of the method according to the invention;
- Figures 6a-6b: show schematic illustrations of an ascertainment of contiguous segments, taking place as part of the method according to the invention, in a state without completely closed edge paths;
- Figure 7: shows a schematic illustration for elucidating further image processing as part of an active contour method; and
- Figures 8a-8b: show schematic illustrations for elucidating a further embodiment of the method according to the invention when applied to the analysis of an SEM image of a wafer.

### DETAILED DESCRIPTION OF PREFERRED EMBODIMENTS

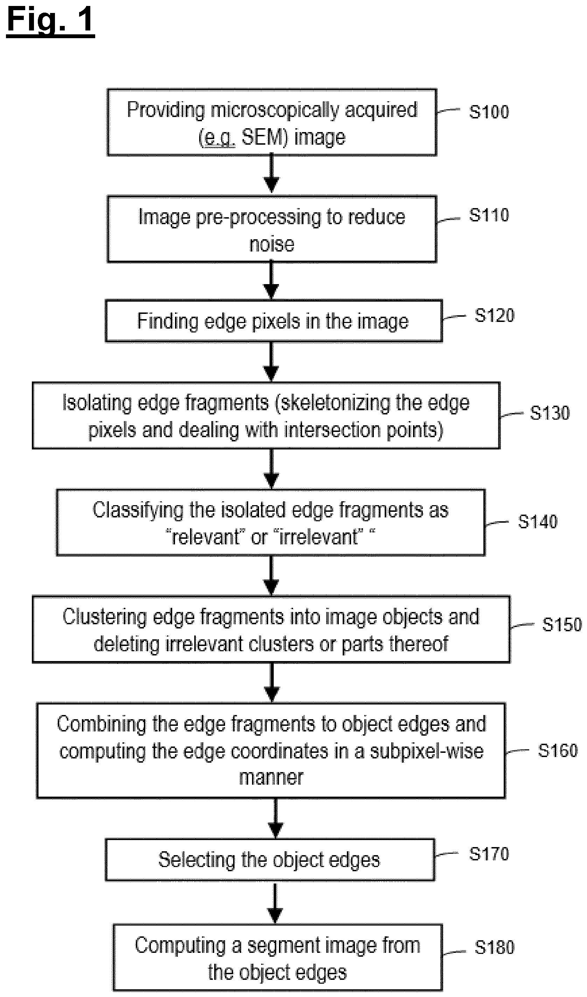

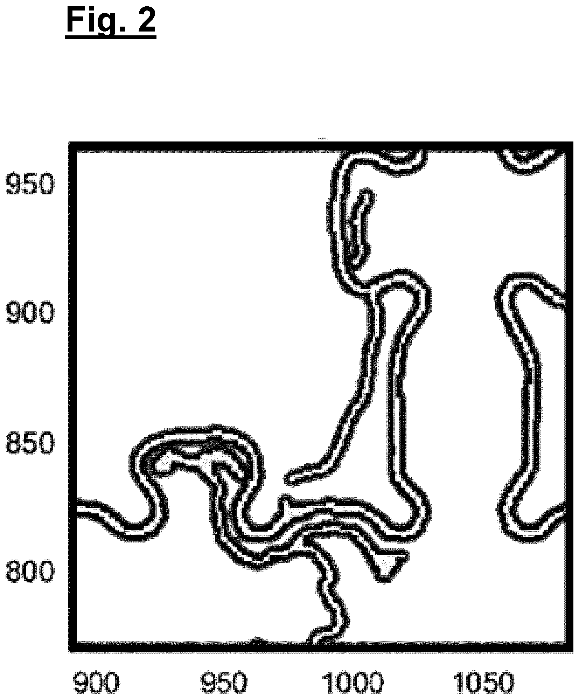

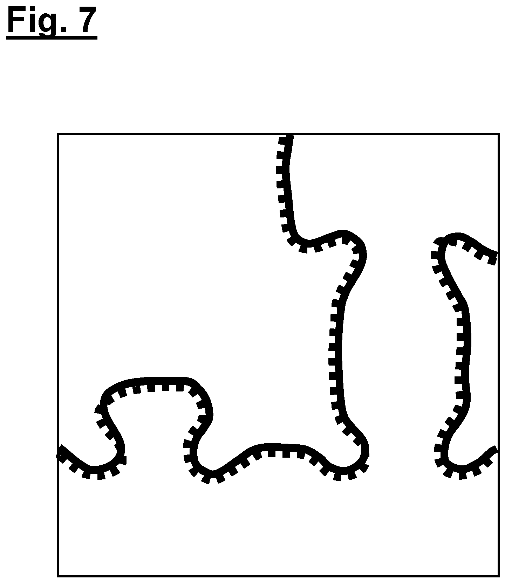

Embodiments of the method according to the invention will be explained in more detail below with reference to the flowchart shown in Fig. 1 and the schematic illustrations of Fig. 2 to Fig. 8.

According to Fig. 1, a microscopically acquired image, e.g. an image of a mask or a wafer recorded by a scanning electron microscope (SEM), is initially provided in a step S100.

The image is then analysed using the method according to the invention, having the method steps which will be described below, to the effect that the regions carrying in each case a coating or structure are differentiated from the structure-less or uncoated regions. With regard to the coated regions, the terms "segments" respectively delimited by "edges" will be used below.

Furthermore, sections of such edges will be referred to below as "edge fragments". Furthermore, the image to be analysed is composed of a multiplicity of pixels, wherein each pixel is assigned an intensity value (as a "greyscale value").

The image to be analysed typically has a pronounced noise component (wherein e.g. pixels having a low intensity value and pixels having a comparatively large intensity value may be immediately adjacent to one another). To reduce said noise, image pre-processing is initially carried out in step S110, wherein in principle any suitable image smoothing methods can be combined with one another. Methods that are suitable for example comprise binning, Gaussian filtering, low-pass filtering etc. Merely by way of example, it is possible here for e.g. four (or possibly more or fewer) mutually adjacent pixels to be replaced in each case by a single pixel, wherein this pixel is then assigned the average intensity value of the four pixels.

In a subsequent step S120, edge pixels are initially identified or extracted from the correspondingly pre-processed or smoothed image. In order to capture in this case all edge pixels if possible, preferably a plurality of edge extraction methods that are known per se in each case are used, or the same edge extraction method is applied multiple times with different parameters. Suitable known methods are, for example, "Canny", "Laplacian of Gaussian", "Sobel" etc.

The edges found or extracted in this step S120 typically also have - as is illustrated by way of example in Fig. 2 - a width (possibly varying along the respective edge) which at least sectionally exceeds the width of one pixel.

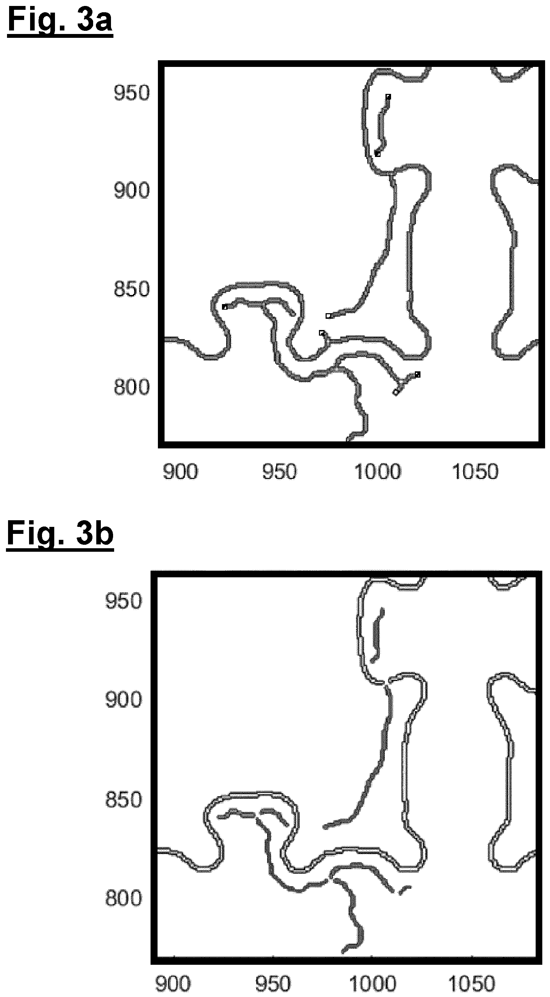

In a subsequent step S130, initially a skeletonization of the edge pixels found previously in step S120 takes place, wherein wider edge fragments are replaced in each case by edge fragments having the width of only one pixel (see Fig. 3a). In this case, it is also possible in particular for two or more narrow edge fragments (each having a width of one pixel) to replace an originally wider edge fragment.

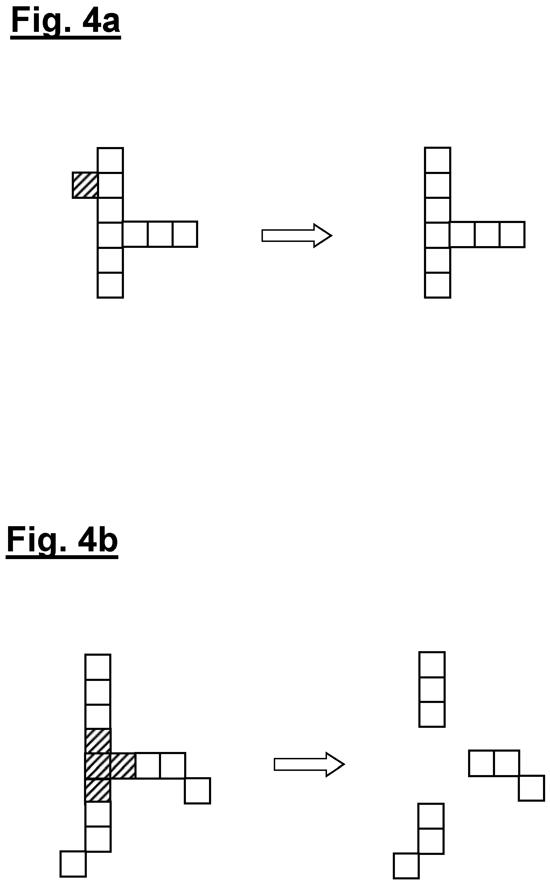

Furthermore, branches or intersection points are also dealt with in step S130. In this case, comparatively short branches (having in particular the length of only one pixel) are deleted, as is illustrated schematically and in highly simplified form in Fig. 4a. If, by contrast, a branch has a greater length (e.g. a length of more than one pixel), the relevant intersection point is deleted with the result that the lines originally coming from said intersection point will now be present in the form of isolated edge fragments, as is illustrated schematically and in highly simplified form in Fig. 4b. This takes account of the fact that, in a "binary" image with only two different types of regions (e.g. coated and uncoated mask regions), the actual existence of such intersection points is ruled out in principle; in other words, at least one of the lines intersecting in said intersection point is "irrelevant" in this respect, that is to say this line does not represent any real transition between the coated and uncoated region.

Subsequently, again with reference to Fig. 1, the previously isolated edge fragments are classified in a further step S140 into "relevant edge fragments" (which in reality represent a transition between a coated and an uncoated region) or "irrelevant edge fragments" (i.e. edge fragments representing no such transition). For this classification (in accordance with an "elimination" of non-relevant or "false" edge fragments), in each case the average intensity gradient is used for the individual edge fragments and compared with a threshold value that has been ascertained in an appropriate manner. Here, only edge fragments for which the average intensity gradient exceeds the ascertained threshold value are considered to be "relevant" within the above meaning.

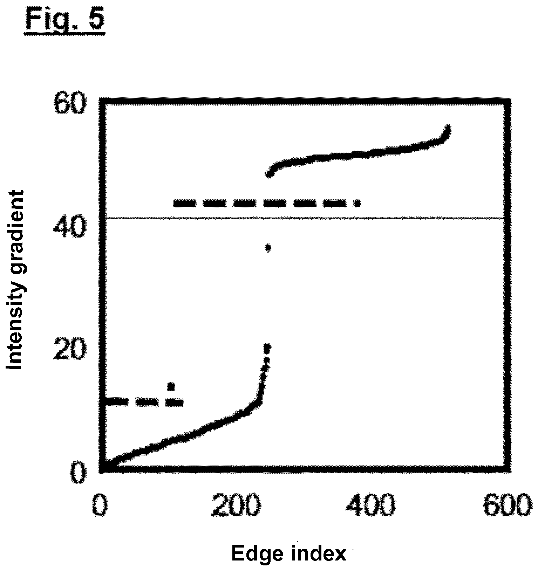

The diagram shown in Fig. 5 shows merely by way of example the potential definition of a threshold value on the basis of an exemplary distribution of values of the average intensity gradient for the edge fragments occurring in the image, wherein each index on the horizontal axis corresponds to an edge fragment and wherein the associated value of the average intensity gradient is plotted on the vertical axis.

Said threshold value is in turn preferably defined according to the invention such that specific edge fragments (i.e. the associated average intensity gradients) either are not taken into account when defining the threshold value or are reduced in terms of the gradient value (i.e. are "weakened"). In particular, particularly short edge fragments, particularly high-contrast edge fragments, particularly low-contrast edge fragments and/or edge fragments located near a comparatively brighter edge fragment are possibly not taken into account during the definition of the threshold value. Furthermore, even edge fragments located close to a relatively bright edge fragment can be initially "weakened", i.e. reduced in terms of the value of the average intensity gradient, before the definition of the threshold value.

The previously described pre-processing has the advantage that any "outliers" amongst the edge fragments or the respective values of the average intensity gradient can initially be eliminated with the result that the respective dispersion of the values of the average intensity gradients for the regions that are ultimately to be differentiated (i.e. "bright" and "dark") are reduced, or the relevant value ranges are "homogenized", as it were.

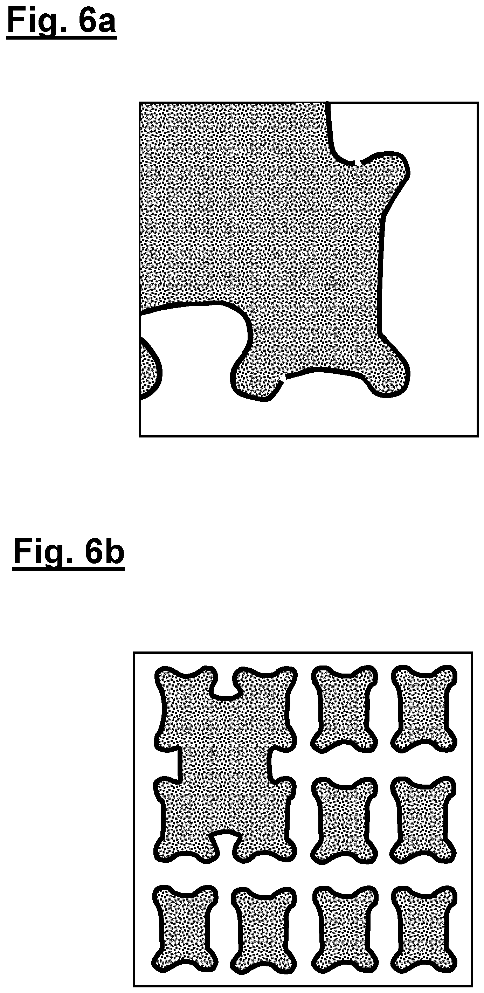

As described below, contiguous segments are ascertained based on the previously classified relevant edge fragments. This ascertainment of contiguous segments is in turn performed preferably without previously closing the gaps that may still be present between said relevant edge fragments, i.e. in a state in which there are not yet any completely closed edge paths (see Fig. 6a).

Again with reference to Fig. 1, in a step S150, edge fragments are clustered into image objects, wherein irrelevant clusters or parts thereof will furthermore be deleted.

Specifically, in step S150, pixels located in interruption regions between successive edge fragments are assigned, in a spacing-based manner, to the one or to the other of the adjoining regions (i.e. the coated or the uncoated region, or the bright segment or the dark segment). With this distance-based assignment, it is possible in particular to complement in each case an existing edge fragment on both sides with in each case a further virtual edge having a width of one pixel, as a result of which it is then possible to ascertain for an edge fragment that is located closest in the interruption region whether it lies closer to the one region (e.g. the region "bright" or the uncoated region) or closer to the other region (e.g. the region "dark" or the coated region). Depending on the result of this distance comparison, each pixel is then assigned to the one or to the other region, such that, as a result of step S150, effectively closed segments are obtained (see Fig. 6b).

Due to the fact that, as has been described above, prior closing of edge paths or edge fragments is dispensed with in the creation of closed segments according to the invention, the method according to the invention is accelerated or simplified, and in addition errors that may be associated with the closing of edge paths are avoided.

Since all edge fragments are now available "in the object context" (i.e. can now be considered in each case to be an integral part either of the coated or of the uncoated region), any remaining objects or edge fragments that in reality clearly do not represent a transition between the coated and the uncoated region can now likewise be eliminated in the image in step S150. These can be in particular objects with comparatively few edge pixels, objects with only one non-closed edge fragment or edge fragments within an object that branches off a closed polygonal chain. The fact that said elimination of individual objects or edge fragments takes place only at this stage of the method (i.e. rather than in one of the preceding steps) has an advantageous effect on the reliability of the method according to the invention, because unauthorized deletion of specific objects or edge fragments - unauthorized since it takes place while said object context is not yet known - is avoided.

Next, in step S160, the edge coordinates are computed in a subpixel-wise manner. For this purpose, the edge fragments are combined into object edges. A subpixel-accurate position computation can be preferably effected with the use of an active contour method. Here, in each case smoothing and/or homogenization of the gradient image can be effected for the purpose of attaining as constant an external energy along the edge as possible. Furthermore, the support points of the edge path between some or all iteration steps of the active contour method can be adapted such that the distance between in each case two support points along the respective edge is substantially constant. Furthermore, the support points of the edge path even between some or all iteration steps of the active contour method can be adapted such that the distance between two support points along the edge in the region of a comparatively more pronounced edge curvature is reduced. Alternatively, the subpixel-wise computation of the edge position can take place by displacing the edge in its normal direction to the place of maximum gradients.

Next, in step S170, the object edges are selected. For this purpose, irrelevant object edges can be eliminated in a manner similar to step S140. Next, in step S180, a segment image is computed from the object edges, wherein the tonality can be determined from the intensity gradients along the respective edges. In addition, the subpixel information of the edge positions can be represented on the basis of greyscale values in the resultant image.

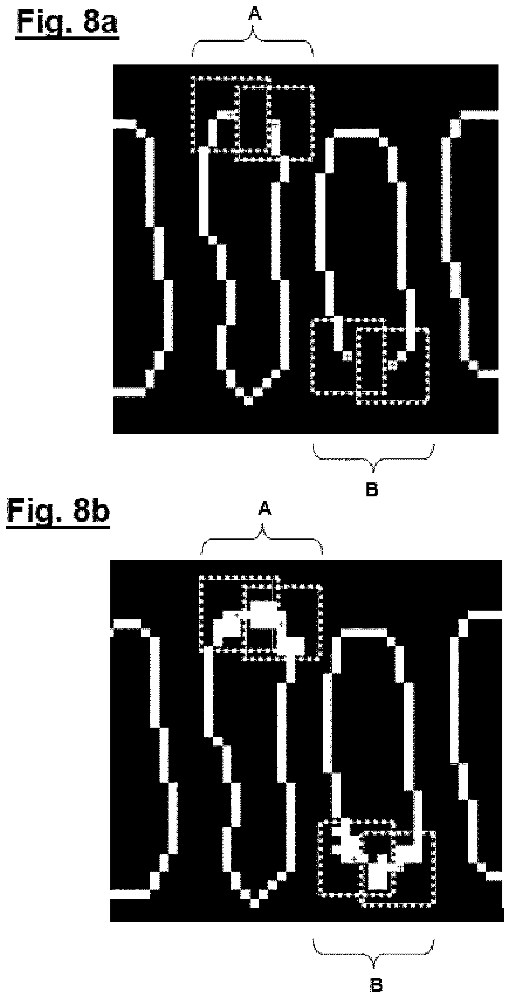

Fig. 8a-8b show schematic illustrations for elucidating a further embodiment of the method according to the invention, wherein, in contrast to the previously described exemplary embodiment, the image to be analysed is an SEM image of a wafer.

Fig. 8a in this respect shows, in a manner similar to Fig. 2, a result obtained as a result of step S120 (i.e. as a result of an edge extraction being carried out), wherein in this case merely by way of example a Canny algorithm was used to perform the edge detection or extraction. As is clear from Fig. 8a, the edges detected here have interruptions in regions denoted by "A" and "B", respectively.

In principle, it is possible in embodiments on the basis of the image presented in Fig. 8a to carry out further processing similar to the exemplary embodiment described previously with reference to Fig. 1-7. However, in a further exemplary embodiment, a "repair" or a closure of the edge path can be effected in the regions "A" and "B". This can be done again by applying a comparatively simple threshold-value-based method to the immediate environment of the interruptions located in the regions "A" and "B". For this purpose, the image according to Fig. 8a is cropped after identification of the interruption regions "A" and "B". In each detail thus produced, edges or contours are produced with a threshold-value-based method that is known per se, wherein the greyscale value of a pixel located in the end section is used as the threshold value for the edge detection or contour generation. The edges or contours extracted in this method thus necessarily run through said end section of the original edge. If two details with the additionally extracted edges or contours overlap according to Fig. 8b, this leads in the exemplary embodiment to a connection between the previously existing end sections and thus to a "repair" of the edge path in the region of the interruption. In turn, a skeletonization of the edges can then be performed for the edge path that has been "repaired" in this manner, similar to the exemplary embodiment described previously with reference to Fig. 1 ff., in order to delimit their widths for example to in each case one pixel.

Even though the invention has been described on the basis of specific embodiments, numerous variations and alternative embodiments will be apparent to a person skilled in the art, for example through combination and/or exchange of features of individual embodiments. Accordingly, it will be apparent to a person skilled in the art that such variations and alternative embodiments are also encompassed by the present invention, and the scope of the invention is restricted only within the scope of the appended patent claims.

## Claims

1. Computer implemented method for analysing an image of a microlithographic microstructured component, wherein in the image each of a multiplicity of pixels is assigned in each case an intensity value, wherein the method comprises the steps of:
- providing a microscopically acquired image (S100);
- identifying edge pixels in the image (step S120);
- isolating a plurality of edge fragments in the image (step S130), after skeletonizing the image, by eliminating branches having lengths that fall below a specified value and/or by eliminating intersection points at which at least three edges intersect;
- classifying each of the isolated edge fragments either as a relevant edge fragment or as an irrelevant edge fragment (step S140) based on the average intensity gradient of isolated edge fragments whether the respective average intensity gradient of an isolated edge fragment exceeds a threshold value; and
- clustering contiguous segments in the image based on the relevant edge fragments (step S150) without prior closing of gaps present between the edge fragments,
wherein for the clustering of contiguous segments (step S150) pixels located in interruption regions between successive edge fragments are assigned, in a spacing-based manner, to the one or to the other of the adjoining regions, wherein an existing edge fragment is complemented on both sides respectively with a further virtual edge having a width of one pixel, and it is ascertained for an edge fragment that is located closest in the interruption region whether it lies closer to the one or to the other of the adjoining regions.

2. Computer implemented method according to Claim 1, **characterized in that** some of the isolated edge fragments are not taken into account for the defining of the threshold value, whereby edge fragments that are not to be taken into account or are to be eliminated can be one or more of the following: particularly short edge fragments, particularly high-contrast edge fragments, particularly low-contrast edge fragments and/or edge fragments located near a relatively brighter edge fragment.

3. Computer implemented method according to any one of the proceeding claims, **characterized in that** furthermore irrelevant edge fragments are eliminated during the clustering of contiguous segments (step S150).

4. Computer implemented method according to any one of the proceeding claims, **characterized in that** edge fragments are combined into object edges and the edge coordinates are computed in a subpixel-wise manner (step S160) after the clustering of contiguous segments (step S150).

5. Computer implemented method according to Claim 4, **characterized in that** irrelevant object edges are eliminated (step S170) after said combination of edge fragments into object edges.

6. Computer implemented method according to Claim 5, **characterized in that** a segment image is computed (step S180) after said elimination of irrelevant object edges (step S170).

7. Computer implemented method according to any one of the proceeding claims, **characterized in that** before a plurality of edge fragments are isolated, image pre-processing (step S110) for reducing the noise component is carried out.

8. Computer implemented method according to any one of the proceeding claims, **characterized in that** the image is divided by way of the segments into a total of two different regions which differ in terms of the material that is located in the respective region.

9. Computer implemented method according to any one of Claims 1 to 8, **characterized in that** the microstructured component is a mask, in particular a mask being designed for a working wavelength of less than 250 nm, more particularly for a working wavelength of less than 200 nm, more particularly for a working wavelength of less than 15 nm.

10. Computer implemented method according to any one of Claims 1 to 8, **characterized in that** the microstructured component is a wafer.

11. Apparatus for analysing an image of a microlithographic microstructured component, **characterized in that** the apparatus is designed to carry out a computer implemented method according to any one of the preceding claims.

## Patentansprüche

1. Computerimplementiertes Verfahren zum Analysieren eines Bildes einer mikrolithographischen mikrostrukturierten Komponente, wobei in dem Bild jedem einer Vielzahl von Pixeln jeweils ein Intensitätswert zugewiesen wird, wobei das Verfahren die folgenden Schritte umfasst:
- Bereitstellen eines mikroskopisch erfassten Bildes (S100);
- Identifizieren von Randpixeln im Bild (Schritt S120);
- Isolieren einer Vielzahl von Randfragmenten in dem Bild (Schritt S130) nach dem Skeletonisieren des Bildes durch Eliminieren von Zweigen mit Längen, die unter einen bestimmten Wert fallen, und/oder durch Eliminieren von Schnittpunkten, an denen sich mindestens drei Ränder schneiden;
- Klassifizieren jedes der isolierten Randfragmente entweder als relevantes Randfragment oder als irrelevantes Randfragment (Schritt S140) basierend auf dem durchschnittlichen Intensitätsgradient isolierter Randfragmente, ob der jeweilige durchschnittliche Intensitätsgradient eines isolierten Randfragments einen Schwellenwert überschreitet; und
- Clustern zusammenhängender Segmente in dem Bild auf der Grundlage der relevanten Randfragmente (Schritt S150) ohne vorheriges Schließen von Lücken zwischen den Randfragmenten;
wobei zum Clustern zusammenhängender Segmente (Schritt S150) Pixel, die sich in Unterbrechungsbereichen zwischen aufeinanderfolgenden Randfragmenten befinden, auf eine abstandsbasierte Weise dem einen oder dem anderen der angrenzenden Bereiche zugewiesen werden,
wobei ein vorhandenes Randfragment beidseitig jeweils mit einem weiteren virtuellen Rand mit einer Breite von einem Pixel ergänzt wird und für ein im Unterbrechungsbereich am nächsten liegendes Randfragment ermittelt wird, ob es näher am einen oder anderen der angrenzenden Bereiche liegt.

2. Computerimplementiertes Verfahren nach Anspruch 1, **dadurch gekennzeichnet, dass** ein Teil der isolierten Randfragmente bei der Festlegung des Schwellenwertes nicht berücksichtigt wird, wobei nicht zu berücksichtigende oder zu eliminierende Randfragmente eines oder mehrere der folgenden sein können: insbesondere kurze Randfragmente, insbesondere kontrastreiche Randfragmente, insbesondere kontrastreiche Randfragmente und/oder Randfragmente, die sich in der Nähe eines relativ helleren Randfragments befinden.

3. Computerimplementiertes Verfahren nach einem der vorhergehenden Ansprüche, **dadurch gekennzeichnet, dass** ferner irrelevante Randfragmente beim Clustern zusammenhängender Segmente eliminiert werden (Schritt S150).

4. Computerimplementiertes Verfahren nach einem der vorhergehenden Ansprüche, **dadurch gekennzeichnet, dass** Randfragmente zu Objekträndern zusammengefasst werden und die Randkoordinaten nach dem Clustern zusammenhängender Segmente subpixelweise berechnet werden (Schritt S160) (Schritt S150).

5. Computerimplementiertes Verfahren nach Anspruch 4, **dadurch gekennzeichnet, dass** nach der Kombination von Randfragmenten zu Objekträndern irrelevante Objektränder eliminiert werden (Schritt S170).

6. Computerimplementiertes Verfahren nach Anspruch 5, **dadurch gekennzeichnet, dass** ein Segmentbild berechnet wird (Schritt S180), nachdem irrelevante Objektränder eliminiert worden sind (Schritt S170).

7. Computerimplementiertes Verfahren nach einem der vorhergehenden Ansprüche, **dadurch gekennzeichnet, dass** vor der Isolierung einer Vielzahl von Randfragmenten eine Bildvorverarbeitung (Schritt S110) zur Reduzierung des Rauschanteils durchgeführt wird.

8. Computerimplementiertes Verfahren nach einem der vorhergehenden Ansprüche, **dadurch gekennzeichnet, dass** das Bild über die Segmente in insgesamt zwei unterschiedliche Bereiche aufgeteilt wird, die sich hinsichtlich des Materials unterscheiden, das sich in dem jeweiligen Bereich befindet.

9. Computerimplementiertes Verfahren nach einem der Ansprüche 1 bis 8, **dadurch gekennzeichnet, dass** die mikrostrukturierte Komponente eine Maske ist, insbesondere eine Maske, die für eine Arbeitswellenlänge von weniger als 250 nm, insbesondere für eine Arbeitswellenlänge von weniger als 200 nm, insbesondere für eine Arbeitswellenlänge von weniger als 15 nm ausgelegt ist.

10. Computerimplementiertes Verfahren nach einem der Ansprüche 1 bis 8, **dadurch gekennzeichnet, dass** die mikrostrukturierte Komponente ein Wafer ist.

11. Vorrichtung zur Analyse eines Bildes einer mikrolithographischen mikrostrukturierten Komponente, **dadurch gekennzeichnet, dass** die Vorrichtung zur Durchführung eines computerimplementierten Verfahrens nach einem der vorhergehenden Ansprüche ausgebildet ist.

## Revendications

1. Procédé mis en œuvre par ordinateur pour analyser une image d'un composant microlithographique microstructuré, chaque pixel d'une multiplicité de pixels dans l'image se voyant affecter dans chaque cas une valeur d'intensité, le procédé comprenant les étapes suivantes :
- obtention d'une image acquise par microscopie (S100) ;
- identification de pixels de bord dans l'image (étape S120) ;
- isolement d'une pluralité de fragments de bord dans l'image (étape S130), après squelettisation de l'image, par élimination de branches ayant des longueurs qui sont inférieures à une valeur spécifiée et/ou par élimination de points d'intersection au niveau desquels au moins trois bords se croisent ;
- classement de chacun des fragments de bord isolés comme un fragment de bord pertinent ou comme un fragment de bord non pertinent (étape S140) sur la base du gradient d'intensité moyen des fragments de bord isolés si le gradient d'intensité moyen respectif d'un fragment de bord isolé dépasse une valeur seuil ; et
- regroupement de segments contigus dans l'image sur la base des fragments de bord pertinents (étape S150) sans fermeture préalable de vides présents entre les fragments de bord,
dans lequel, pour le regroupement de segments contigus (étape S150), des pixels situés dans des régions d'interruption entre fragments de bord successifs sont affectés, sur la base d'un espacement, à l'une ou l'autre des régions attenantes,
dans lequel un fragment de bord existant est respectivement complété sur les deux côtés par un bord virtuel supplémentaire ayant une largeur d'un pixel, et on vérifie pour un fragment de bord qui est le plus proche dans la région d'interruption s'il est plus proche de l'une ou l'autre des régions attenantes.

2. Procédé mis en œuvre par ordinateur selon la revendication 1, **caractérisé en ce que** certains des fragments de bord isolés ne sont pas pris en compte pour la définition de la valeur seuil, les fragments de bord qui ne doivent pas être pris en compte ou doivent être éliminés pouvant être un ou plusieurs des fragments suivants : fragments de bord particulièrement courts, fragments de bord à particulièrement fort contraste, fragments de bord à particulièrement faible contraste et/ou fragments de bord situés près d'un fragment de bord relativement plus lumineux.

3. Procédé mis en œuvre par ordinateur selon l'une quelconque des revendications précédentes, **caractérisé en ce que** des fragments de bord non pertinents sont en outre éliminés pendant le regroupement de segments contigus (étape S150).

4. Procédé mis en œuvre par ordinateur selon l'une quelconque des revendications précédentes, **caractérisé en ce que** des fragments de bord sont combinés en bords d'objet et les coordonnées de bord sont calculées à l'échelle des sous-pixels (étape S160) après le regroupement de segments contigus (étape S150).

5. Procédé mis en œuvre par ordinateur selon la revendication 4, **caractérisé en ce que** des bords d'objet non pertinents sont éliminés (étape S170) après ladite combinaison de fragments de bord en bords d'objet.

6. Procédé mis en œuvre par ordinateur selon la revendication 5, **caractérisé en ce qu'**une image de segment est calculée (étape S180) après ladite élimination de bords d'objet non pertinents (étape S170).

7. Procédé mis en œuvre par ordinateur selon l'une quelconque des revendications précédentes, **caractérisé en ce qu'**avant l'isolement d'une pluralité de fragments de bord, un prétraitement d'image (étape S110) destiné à réduire la composante de bruit est réalisé.

8. Procédé mis en œuvre par ordinateur selon l'une quelconque des revendications précédentes, **caractérisé en ce que** l'image est divisée au moyen des segments en un total de deux régions différentes qui diffèrent par le matériau qui se trouve dans la région respective.

9. Procédé mis en œuvre par ordinateur selon l'une quelconque des revendications 1 à 8, **caractérisé en ce que** le composant microstructuré est un masque, en particulier un masque conçu pour une longueur d'onde de travail inférieure à 250 nm, plus particulièrement pour une longueur d'onde de travail inférieure à 200 nm, plus particulièrement pour une longueur d'onde de travail inférieure à 15 nm.

10. Procédé mis en œuvre par ordinateur selon l'une quelconque des revendications 1 à 8, **caractérisé en ce que** le composant microstructuré est une tranche.

11. Appareil destiné à analyser une image d'un composant microlithographique microstructuré, **caractérisé en ce que** l'appareil est conçu pour réaliser un procédé mis en œuvre par ordinateur selon l'une quelconque des revendications précédentes.
